# EUROPEAN PATENT APPLICATION

(11) **EP 3 863 015 A1**
(43) Date of publication of application: **11.08.2021**
(21) Application number: 20315013.1
(22) Date of filing: 07.02.2020
(51) Int. Cl.: G11C 11/16

(54) **MAGNETORESISTIVE MEMORY CELL HAVING DETERMINISTIC SWITCHING AND IMPROVED ENERGY EFFICIENCY**

(71) Applicant: Antaios, 38240 Meylan (FR)
(72) Inventor: MARTIN, Sylvain, 38100 Grenoble (FR); NOZIERES, Jean-Pierre, 38700 Le Sappey-en-Chartreuse (FR); DROUARD, Marc, 26000 Valence (FR); KULA, Witold, Gilroy, CA 95020 (US)
(74) Representative: P&TS SA (AG, Ltd.)

(57) **Abstract**

The present disclosure concerns a magnetoresistive memory cell, comprising: comprising a tunnel barrier layer (22), a first ferromagnetic layer (21) and a second ferromagnetic layer (23) having a second magnetization (230); a current layer (30) extending substantially parallel to the first and second ferromagnetic layers (21, 23) and contacting the second ferromagnetic layer (23) in a contact portion (32), the current layer (30) being configured for passing a writing current (31) for switching the second magnetization (230) by a spin orbit torque (SOT) interaction; wherein the cell further comprises an enhancing layer (50) extending substantially parallel to the current layer (30) and comprising an electrically conductive portion (52) for passing the writing current (31) and a resistive portion (53) extending in the contact region (32) and having an electrical conductivity being at least ten times smaller than that of the current layer (30) and the electrically conductive portion (52); the enhancing layer (50) being configured for providing a magnetic bias field (61) to deterministically switch the second magnetization (230) when the writing current (31) is passed.

## Description

### Field

The present invention relates to a magnetoresistive memory cell and more particularly a magnetoresistive memory cell that is deterministically switchable by a writing current using a SOT interaction and that has improved energy efficiency.

### Description of related art

In a magnetoresistive memory cell, such as an MRAM, data is read and written using characteristics in which an element resistance of a TMR element changes when magnetization directions of two ferromagnetic layers sandwiching an insulating layer change. As writing methods for MRAMs, a method in which writing (magnetization reversal) is performed using a magnetic field produced by a current and a method in which writing (magnetization reversal) is performed using a spin transfer torque (STT) occurring when a current flows in a lamination direction of a magnetoresistance effect element are known. Magnetization reversals of TMR elements using an STT can be efficient in view of energy efficiency, but a reversal current density causing magnetization reversal to be performed induces high voltage across the TMR element thus lowering the TMR element life. In terms of a long life of TMR elements, it is desirable that reversal current densities be low or to avoid having the reversal currents to flow through the TMR element.

Therefore, in recent years, magnetization reversal in which magnetization is reversed by a mechanism different from an STT as a means for eliminating a writing current having to flow through the TMR element in which a spin orbit torque (SOT) generates a spin current, has been attracting attention.

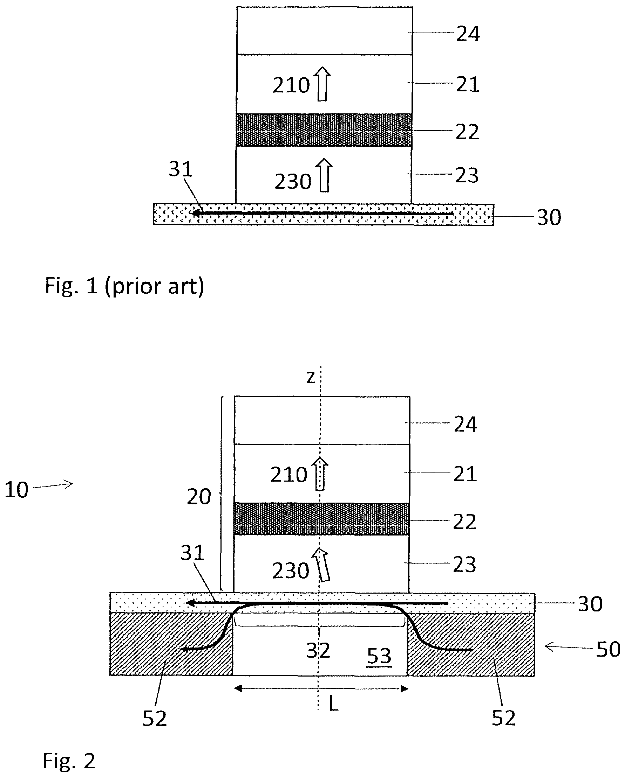

Fig 1 shows a conventional magnetoresistive memory cell comprising a tunnel barrier layer 22 sandwiched between a first ferromagnetic layer 21 having a first magnetization 210, and a second ferromagnetic layer 23 having a free second magnetization 230. The second magnetization 230 can be switched by passing a writing current 31 in a current line 30 in contact with the second magnetization 230. The SOT based switching allows for using separate read- and write-paths which is beneficial for a long life of the memory cell. In the case the magnetizations 210 and 230 are perpendicular to the plane of the layers 21, 23, such as in SOT-switching based magnetoresistive memory cell that are required for high-density memory, an in-plane magnetic field (not shown) has to be applied in addition to the writing current 31 in order to deterministically switch the second magnetization 230. However, the need for an external applied field significantly hinders the technological viability of commercial applications.

Additional magnetic layers, such as magnetic layers providing exchange bias or interlayer exchange coupling, can be added to the current line 30 in order to achieve deterministic switching of the second magnetization 230. However, such layers are electrically conductive and increase the overall thickness of the conductive material where the writing current 31 passes without contributing to generating additional spin current. Thus, in order to obtain the same spin current entering the second ferromagnetic layer 23, a higher writing current 31 must be used.

### Summary

The present disclosure concerns a magnetoresistive memory cell, comprising a magnetic tunnel junction comprising a tunnel barrier layer sandwiched between a first ferromagnetic layer having a first magnetization, and a second ferromagnetic layer having a second magnetization; a current layer extending in a plane substantially parallel to the first and second ferromagnetic layers and contacting the second ferromagnetic layer in a contact portion, the current layer being configured for passing a writing current for switching the second magnetization by a SOT interaction; wherein the magnetoresistive memory cell further comprises an enhancing layer extending substantially parallel to the current layer; the enhancing layer comprising an electrically conductive portion configured for passing the writing current, and a resistive portion extending in the contact region and having an electrical conductivity being at least ten times smaller than that of the current layer and the electrically conductive portion; and wherein the enhancing layer is configured for providing a magnetic bias field to the second magnetization to allow deterministically switching of the second magnetization from a first to a second magnetization state when the writing current is passed.

The magnetoresistive memory cell disclosed herein allows for maximizing the part of the writing current that generates the spin current through the SOT effect, for a given writing current magnitude, while keeping or reducing the overall resistance of the current layer. Therefore, the magnetoresistive memory cell has increased energy efficiency.

### Brief Description of the Drawings

The invention will be better understood with the aid of the description of an embodiment given by way of example and illustrated by the figures, in which:
Fig. 1 shows a conventional magnetoresistive memory cell;
Fig. 2 shows a side view of a magnetoresistive memory cell comprising an enhancing layer including an electrically conductive portion and a resistive portion, according to an embodiment;
Fig. 3 shows a side view of the magnetoresistive memory cell wherein the electrically conductive portion is also magnetic, according to an embodiment;
Fig. 4 shows a side view of the magnetoresistive memory cell wherein the composite layer comprises side walls, according to an embodiment;
Fig. 5 shows a side view of the magnetoresistive memory cell wherein the electrically conductive portion comprises a synthetic antiferromagnet, according to an embodiment;
Fig. 6 shows a side view of the magnetoresistive memory cell wherein the enhancing layer comprises a coupling magnetic layer, according to an embodiment;
Fig. 7 shows the magnetoresistive memory cell of Fig. 6, according to another embodiment;
Fig. 8 shows the magnetoresistive memory cell of Fig. 6, according to yet another embodiment;
Fig. 9 shows the magnetoresistive memory cell wherein the resistive portion comprises a magnetic material having a bias magnetization, according to an embodiment; and
Fig. 10 shows the magnetoresistive memory cell comprising vias.

### Detailed Description of possible embodiments

Fig. 2 shows a side view of a magnetoresistive memory cell 10, according to an embodiment. The magnetoresistive memory cell 10 comprises a magnetic tunnel junction (MTJ) 20 comprising a tunnel barrier layer 22 sandwiched between a first ferromagnetic layer 21 having a first magnetization 210, and a second ferromagnetic layer 23 having a second magnetization 230. The magnetoresistive memory cell 10 further comprises a current layer 30 extending in a plane substantially parallel to the first and second ferromagnetic layers 21, 23 and contacting the second ferromagnetic layer 23 in a contact portion 32 of the current layer 30. The current layer 30 is configured for passing a writing current 31 adapted for switching the second magnetization 230 by a SOT interaction. In particular, the spin current generated by writing current 31 exerts a torque on the initial orientation of the second magnetization 230 so that the orientation of the second magnetization 230 can be changed, for example, from being parallel to antiparallel to the first magnetization 210. In Fig. 2, the contact portion 32 corresponds to the lateral dimension of the MTJ 20.

The magnetoresistive memory cell 10 further comprises an enhancing layer 50 extending substantially parallel to the current layer 30 and configured for passing the writing current. The enhancing layer 50 has a higher resistance in the contact portion 32 than in the rest of the enhancing layer. The enhancing layer 50 is further configured for providing a magnetic bias field 61 to deterministically switch the second magnetization 230 from a first to a second magnetization state when the writing current 31 is passed.

The enhancing layer 50 allows for reducing the resistance along the path of the writing current 31 without decreasing the part of the writing current generating spin current through the SOT effect. Here, the path of the writing current 31 comprises the current layer 30, the second ferromagnetic layer 23 and the enhancing layer 50. The portion of the writing current 31 that generates the spin current through the SOT effect can thus be maximized for a given writing current magnitude, while keeping or reducing the overall resistance of the current layer 30.

In the specific embodiment of Fig. 2, the enhancing layer 50 extends substantially parallel to the current layer 30 on the side of the current layer 30 opposite to the one contacting the MTJ 20. The enhancing layer 50 comprises an electrically conductive portion 52 and a resistive portion 53. The resistive portion 53 extends along the contact portion 32 and has an electrical conductivity being at least ten times smaller than that of the current layer 30 and the electrically conductive portion 52.

The writing current 31 can flow in the electrically conductive portion 52 and in the current layer 30. Since the writing current 31 does not flow in the resistive portion 53, the portion of the writing current 31 in the contact portion 32, generating a spin current, is the same than in the absence of the enhancing layer 50 (i.e., when the writing current 31 flows only in the current layer 30). Outside the contact portion 32, the writing current 31 can flow in the current layer 30 and in the electrically conductive portion 52 and the overall resistance along the path of the writing current 31 is reduced. In fact, the combination of the current layer 30 with the electrically conductive portion 52 can be equated to a resistance decrease only outside the contact portion 32.

In the example of Fig. 2, the lateral dimension of the resistive portion 53 corresponds to the lateral dimension L of the MTJ 20, for example the diameter of the MTJ 20 for a circular or ellipsoidal MTJ. However, it has been observed that the decrease of the resistance along the writing current path can be achieved for the lateral dimension of the resistive portion 53 between 0.3L and 5L but preferably between 0.5L and 3L.

The resistive portion 53 can be made from a dielectric oxide such as SiOx, AlOx, MgOx, TaOx, HfOx, or a dielectric nitride such as SiN, BNx. The resistive portion 53 can have a resistivity above 10⁻⁵ Ωm.

The current layer 30 is electrically is conductive and can be made of a non-magnetic material, such as Pt, W, Ir, Ru, Pd, Cu, Au, Bi, Hf, Se, Sb or of an alloy of these metals, or is formed of a stack of a plurality of layers of each of these metals. Alternatively, the current layer 30 can be made from an antiferromagnetic material. Examples of antiferromagnetic materials include alloys with a base of Mn such as IrMn, FeMn, PtMn, or alloys of these compounds such as PtFeMn.

The thickness of the current layer 30 can be between 0.5 nm and 200 nm, more particularly between 0.5 nm and 100 nm, or less than 10 nm. Preferably, the current layer 30 has thickness lying in the range 0.5 nm to 5 nm. As an example, the writing current 31 adapted for switching the second magnetization 230 can have a current density between 10⁵ A/cm² and 10⁸ A/cm².

The current layer 30 can be in contact with the second ferromagnetic layer 23. Alternatively, a thin separating layer (not shown) can be provided between the current layer 30 and the second ferromagnetic layer 23. For example, the thin separating layer can comprise a layer of MgO that lets the spin current pass but less net charge current, such that a lesser portion of the writing current 31 passes thought the second ferromagnetic layer 23 and a greater portion of the writing current 31 passes through the current layer 30. The thin separating layer can also enhance an out-of-plan second magnetization 230 through the interfacial anisotropy at the interface between the layer 23 and the separating layer.

In an embodiment, the second ferromagnetic layer 23 can comprise a metal or alloy having a specific perpendicular magnetic anisotropy whereby the second magnetization 230 is oriented perpendicular to the plane of the second ferromagnetic layer 23 (out-of-plane). Such metal or alloy can comprise FePt, FePd, CoPt, or a rare earth/transition metal alloy, in particular GdCo, TdFeCo, or Co, Fe, CoFe, Ni, CoNi, CoFeB, FeB. Alternatively, the second ferromagnetic layer 23 can comprise a metal or alloy with the second magnetization 230 being oriented parallel to the plane of the second ferromagnetic layer 23 (in-plane). Such metal or alloy can comprise Co, Fe, CoFe, Ni, NiFe, CoNi, CoFeB, FeB. The first magnetization 210 should be oriented correspondingly to the second magnetization 230. In other words, both the first magnetization 210 and the second magnetization 230 should be in-plane or out-of-plane.

The thickness of the second ferromagnetic layer 23 can be smaller than 5 nm.

The MTJ 20 can comprise a first antiferromagnetic layer 24 exchange coupling the first magnetization 210 such as to pin it in a particular direction. Alternatively, the MTJ 20 can comprise a SAF structure 24 with the layer 21. The SAF structure 24 can comprise a metallic non-magnetic spacer layer and a ferromagnetic layer.

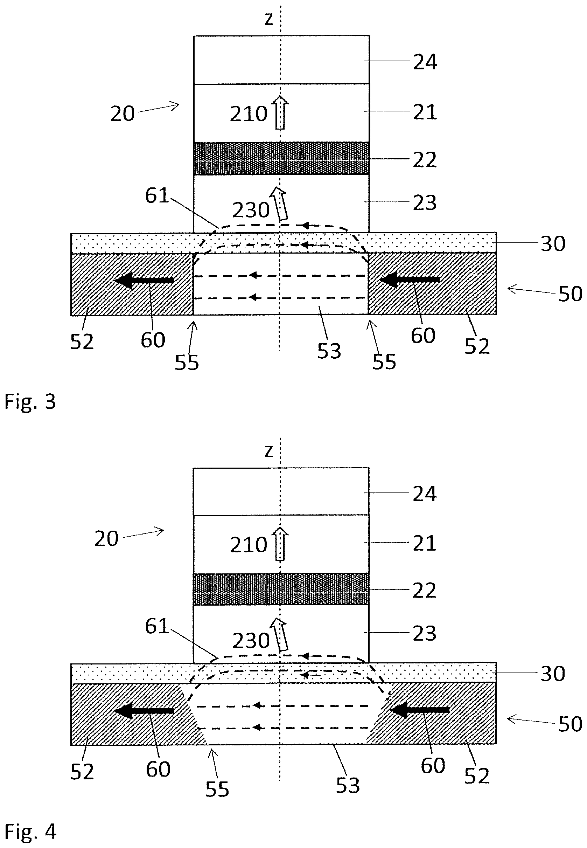

In an embodiment illustrated in Fig. 3, the conductive portion 52 comprises an electrically conductive magnetic material having a bias magnetization 60 configured to provide the magnetic bias field 61. The conductive portion 52 can be made of a metal or alloy comprising: Co, Fe, CoFe, Ni, NiFe, CoNi, CoCrPt, CoPt, CoCrTa, CoSm or any combination of these metals or alloys. The bias magnetization 60 generates a stray field 61 at an interface 55 between the electrically conductive portion 52 and the resistive portion 53. The stray field 61 acts as the magnetic bias field being used to break the symmetry allowing to switch deterministically the second magnetization 230 from a first to a second magnetization state when the writing current 31 is passed.

In the particular example of Fig. 3, the interface 55 comprises side walls making an angle of substantially 90° relative to the plane of the first and second ferromagnetic layers 21, 23. The first and second magnetizations 210, 230 are oriented perpendicular to the plane of the layers 21, 23 (oriented out-of-plane) and the bias magnetization 60 and magnetic bias field 61 are oriented substantially in plane. In the presence of the magnetic bias field 61, the storage magnetization 230 is tilted relative to its initial out-of-plane orientation. The tilting provides the deterministic switching of the second magnetization 230 by the writing current 31. Note that the bias magnetization 60 can be oriented in a direction opposite to the one shown in Fig. 3.

In a variant illustrated in Fig. 4, the interface 55 comprises side walls having a slope angle relative to different from 90°. For example, the walls can make an angle between 20° and 90°, preferably between 60° and 80°, relative to the plane of the first and second ferromagnetic layers 21, 23.

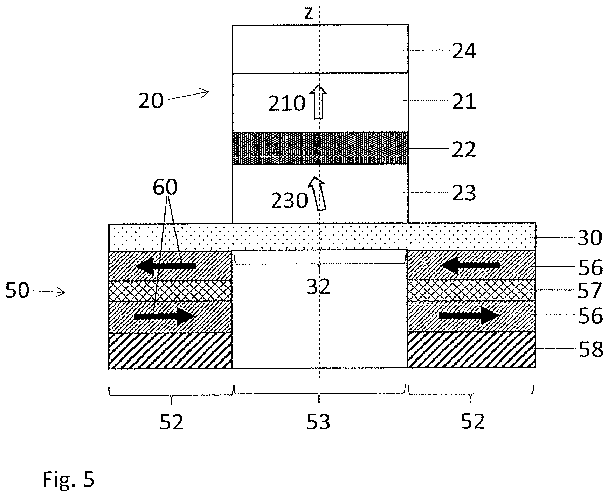

In another variant illustrated in Fig. 5, the magnetic and electrically conductive portion 52 comprises a multilayer including two ferromagnetic layers 56 separated by a non-magnetic spacer layer 57 providing a Ruderman-Kittel-Kasuya-Yosida (RKKY) coupling. The spacer layer 57 can comprise an element such as Ru, Ir or Cu or a combination of these elements. The multilayer can comprises more that two ferromagnetic layers, each being separated by a spacer layer 57. The thickness of the spacer layer 57 can be tuned in order to determine the orientation of the bias magnetization 60 in the ferromagnetic layers 56 closest to the current layer 30. For example, depending on the thickness of the spacer layer 57, the coupling can be antiferromagnetic (positive exchange coupling in a RKKY thickness dependence curve) such as to provide an antiparallel coupling between the two ferromagnetic layers 56, or can be ferromagnetic (negative exchange coupling in a RKKY thickness dependence curve) such as to provide a parallel coupling between the two ferromagnetic layers 56.

The magnetic and electrically conductive portion 52 can further comprise an enhancing antiferromagnetic layer 58 exchange coupling the bias magnetization 60 via the ferromagnetic layer 56 such as to pin it in a particular direction.

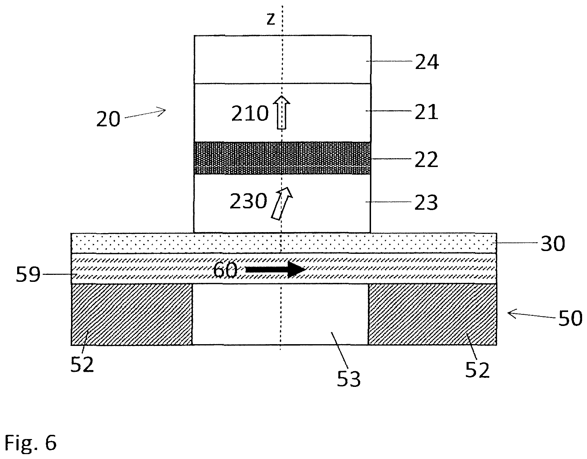

In another embodiment illustrated in Fig. 6, the enhancing layer 50 comprises a coupling magnetic layer 59 extending substantially parallel to the current layer 30. The coupling magnetic layer 59 comprises a conductive magnetic material having a bias magnetization 60 configured to provide the magnetic bias field 61 via interlayer exchange coupling to break the symmetry allowing to switch deterministically the second magnetization 230 from a first to a second magnetization state when the writing current 31 is passed. The coupling magnetic layer 59 can be made from ferromagnetic material such as a metal or alloy comprising Co, Fe, CoFe, Ni, NiFe, CoNi. The current layer 30 can be made from a metal or alloy capable of generating a spin current by spin orbit and allowing interlayer exchange coupling when the current layer 30 is sandwiched by two ferromagnetic layers. In the example of Fig. 6, the current layer 30 can be configured to allow the interlayer exchange coupling between the coupling magnetic layer 59 and the second ferromagnetic layer 23 such that the bias magnetization 60 biases the second magnetization 230 and tilt it according to the direction of the bias magnetization 60. The current layer 30 can be made from, but not limited to, Ir or Ru.

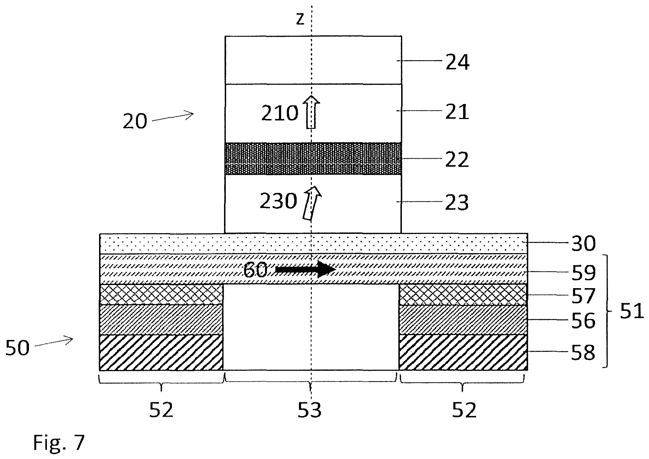

The embodiment illustrated in Fig. 7 is a variant of the configuration shown in Fig. 6 wherein the electrically conductive portion 52 comprises a ferromagnetic layer 56 separated from the coupling magnetic layer 59 by a spacer layer 57 providing a RKKY coupling. The electrically conducting portion 52 can comprises more that two ferromagnetic layers, each being separated by a spacer layer 57. The thickness of the spacer layer 57 can be tuned in order to determine the orientation of the bias magnetization 60 in the coupling magnetic layer 59. The electrically conductive portion 52 can further comprise an enhancing antiferromagnetic layer 58 exchange coupling the bias magnetization 60 via the ferromagnetic layer 56 such as to pin it in a particular direction.

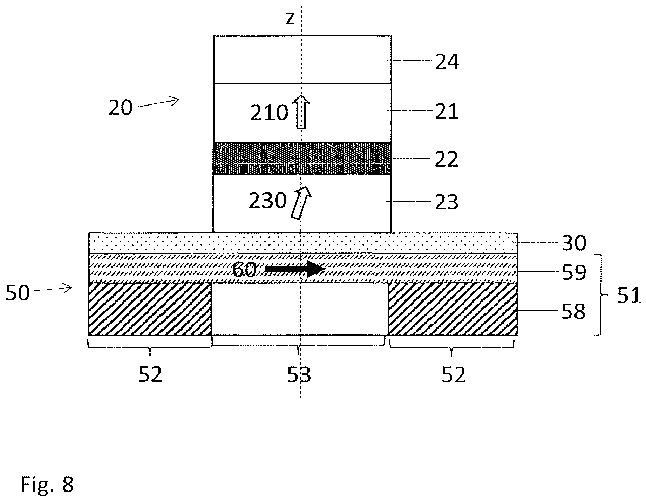

In a variant shown in Fig. 8, the electrically conductive portion 52 comprises solely an enhancing antiferromagnetic layer 58 exchange coupling the bias magnetization 60 such as to pin it in a particular direction.

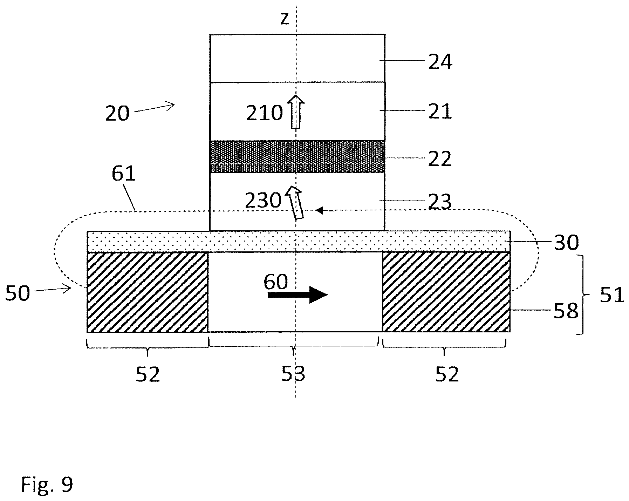

In yet another embodiment illustrated in Fig. 9, the resistive portion 53 comprises a magnetic material having a bias magnetization 60 configured to provide the magnetic bias field 61. The conductive portion 52 can comprise an electrically conductive non-magnetic material or an electrically conductive magnetic material. In a possible configuration, the conductive portion 52 can comprise an electrically conductive antiferromagnetic material. The antiferromagnetic material comprising conductive portion 52 can then be used to exchange couple the bias magnetization 60 of the resistive portion 53 such as to pin it in a particular direction.

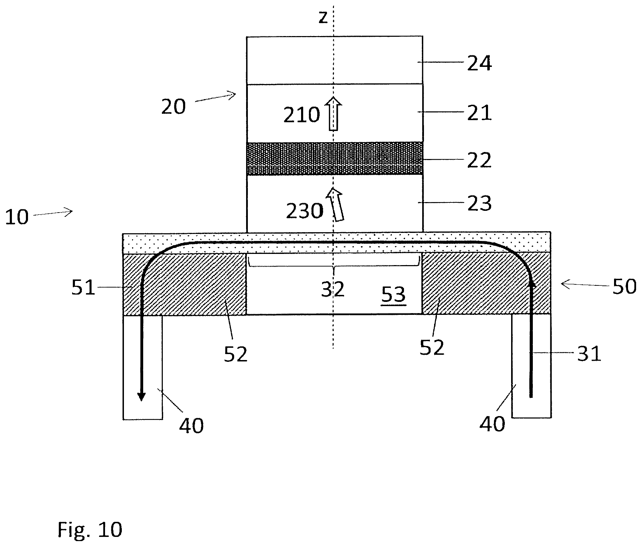

In one aspect, the magnetoresistive memory cell 10 comprises electrically conductive vias 40 electrically connected to the electrically conductive portion 52 of the composite layer 51 (see Fig. 10). The vias 40 can be connected to transistor (not shown) controlling the magnetoresistive memory cell 10.

### Reference numbers and symbols

- 10: magnetoresistive memory cell
- 20: magnetic tunnel junction
- 21: first ferromagnetic layer
- 210: first magnetization
- 22: tunnel barrier layer
- 23: second ferromagnetic layer
- 230: second magnetization
- 24: first antiferromagnetic layer
- 30: current layer
- 31: writing current
- 32: contact portion
- 40: via
- 50: enhancing layer
- 51: composite layer
- 52: electrically conductive portion
- 53: resistive portion
- 55: interface
- 56: ferromagnetic layer
- 57: spacer layer
- 58: enhancing antiferromagnetic layer
- 59: coupling magnetic layer
- 60: bias magnetization
- 61: magnetic bias field
- L: lateral dimension
- z: out-of-plane direction

## Claims

1. magnetoresistive memory cell, comprising:
a magnetic tunnel junction (20) comprising a tunnel barrier layer (22) sandwiched between a first ferromagnetic layer (21) having a first magnetization (210), and a second ferromagnetic layer (23) having a second magnetization (230);
a current layer (30) extending in a plane substantially parallel to the first and second ferromagnetic layers (21, 23) and contacting the second ferromagnetic layer (23) in a contact portion (32) of the current layer (30), the current layer (30) being configured for passing a writing current (31) for switching the second magnetization (230) by a spin orbit torque (SOT) interaction;
**characterized in that** the memory cell further comprises an enhancing layer (50) extending substantially parallel to the current layer (30); the enhancing layer comprising an electrically conductive portion (52) configured for passing the writing current (31), and a resistive portion (53) extending in the contact region (32) and having an electrical conductivity being at least ten times smaller than that of the current layer (30) and the electrically conductive portion (52);
and **in that** the enhancing layer (50) is configured for providing a magnetic bias field (61) to allow deterministically switching of the second magnetization (230) from a first to a second magnetization state when the writing current (31) is passed.

2. The memory cell, according to claim 1
wherein the conductive portion (52) comprises an electrically conductive magnetic material having a bias magnetization (60) providing the magnetic bias field (61).

3. The memory cell, according to claim 2;
wherein the electrically conductive portion (52) comprises at least two ferromagnetic layers (56) separated by a spacer layer (57) providing an antiparallel coupling between the two ferromagnetic layers (56).

4. The memory cell, according to claim 2 or 3
wherein the electrically conductive portion (52) comprises an antiferromagnetic layer (24) exchange coupling the electrically conductive portion (52) such as to pin the bias magnetization (60).

5. The memory cell, according to according to any one of claims 1 to 4,
wherein the resistive portion (53) comprises a magnetic material having a bias magnetization (60) configured to provide the magnetic bias field (61).

6. The memory cell, according to according to claim 1,
wherein the resistive portion (53) comprises a magnetic material having a bias magnetization (60) configured to provide the magnetic bias field (61); and
wherein the conductive portion (52) comprises an electrically conductive non-magnetic material.

7. The memory cell, according to any one of claims 2 to 6;
wherein the magnetic bias field (61) comprises a stray field generated at an interface (55) between the electrically conductive portion (52) and the resistive portion (53).

8. The memory cell, according to claim 7,
wherein the interface (55) comprises side walls making an angle of substantially 90° relative to the plane of the first and second ferromagnetic layers (21, 23).

9. The memory cell, according to claim 7,
wherein the interface (55) comprises side walls having a slope angle between 20° and 90°, preferably between 60° and 80° relative to the plane of the first and second ferromagnetic layers (21, 23).

10. The memory cell, according to any one of claims 1 to 9,
wherein the enhancing layer (50) comprises a coupling magnetic layer (59) extending substantially parallel to the current layer (30); and
wherein the coupling magnetic layer (59) comprises a conductive magnetic material having a bias magnetization (60) configured to provide the magnetic bias field (61) via interlayer exchange coupling.

11. The memory cell, according to claim 1 and claim 10,
wherein the coupling magnetic layer (59) is comprised between the current layer (30) and the electrically conductive portion (52) and resistive portion (53).

12. The memory cell, according to any one of claims 11;
wherein the electrically conductive portion (52) comprises an enhancing antiferromagnetic layer (58) exchange coupling the bias magnetization (60) such as to pin it in a particular direction.

13. The memory cell, according to claim 11 or 12;
wherein the electrically conductive portion (52) comprises at least one ferromagnetic layer (56) separated from the coupling magnetic layer (59) by a coupling layer (57) providing a RKKY coupling.

14. The memory cell, according to any.one of claims 1 to 13,
wherein a lateral dimension of the resistive portion (53) is between 0.3L and 5L, where L is a lateral dimension L of the magnetic tunnel junction (20).

15. The memory cell, according to any one of claims 1 to 14;
wherein the second magnetization (230) is oriented perpendicular to the plane of the second ferromagnetic layer (23).
